# EUROPEAN PATENT APPLICATION

(11) **EP 2 416 357 A2**
(43) Date of publication of application: **08.02.2012**
(21) Application number: 10195217.4
(22) Date of filing: 15.12.2010
(51) Int. Cl.: H01L 23/367

(54) **Methods of forming a thermal conduction region in a semiconductor structure and structures resulting therefrom**

(30) Priority: 15.12.2009 US 286440 P; 30.12.2009 US 291165 P; 14.12.2010 US 967246
(71) Applicant: Intersil Americas Inc., Milpitas, CA 95035 (US)
(72) Inventor: Gaul, Stephen J., Melbourne Village, FL 32904 (US); Church, Michael D., Sebastian, FL 32958 (US); Jerome, Rick Carlton, Indiatlantic, FL 32903 (US)
(74) Representative: Fleuchaus, Michael A.

(57) **Abstract**

An electronic system, method of manufacture of a semiconductor structure, and one or more semiconductor structures are disclosed. For example, a method of manufacture of a semiconductor structure is disclosed, which includes forming a semiconductor layer over a thermal conduction layer, forming an isolation region over the thermal conduction layer, and forming a thermal conduction region in the isolation region.

## Description

### CROSS REFERENCE TO RELATED APPLICATIONS

This application is related to U.S. Provisional Patent Application Serial No. 61/285,325 (attorney docket number SE-2741-TD) entitled "HEAT CONDUCTION FOR CHIP STACKS AND 3-D CIRCUITS," filed on December 10, 2009 and incorporated herein by reference. This application is also related to U.S. Provisional Patent Application Serial No. 61/286,440 (attorney docket number SE-2706-IP) entitled "SEEDED DIAMOND FILM METHOD/DIAMOND DAMASCENE METHOD," filed on December 15, 2009, and U.S. Provisional Patent Application Serial No. 61/291,165 (attorney docket number SE-2717-TD) entitled "TRENCH ISOLATION USING DIAMOND REFILL," filed on December 30, 2009, both of which are incorporated herein by reference. This application hereby claims to the benefit of U.S. Provisional Patent Applications Serial Nos. 61/286,440 and 61/291,165.

### BRIEF DESCRIPTION OF THE DRAWINGS

Understanding that the drawings depict only exemplary embodiments and are not therefore to be considered limiting in scope, the exemplary embodiments will be described with additional specificity and detail through the use of the accompanying drawings, in which:

Figure 1 is a block diagram of an exemplary electronic system that can be utilized to implement one or more embodiments of the present invention;

Figure 2 is a first side elevation, cross-sectional in-process view of a semiconductor structure that can be fabricated in accordance with one embodiment of the present invention;

Figure 3 is a second side elevation, cross-sectional in-process view of a semiconductor structure that can be fabricated in accordance with one embodiment of the present invention;

Figure 4 is a third side elevation, cross-sectional in-process view of a semiconductor structure that can be fabricated in accordance with one embodiment of the present invention;

Figure 5 is a fourth side elevation, cross-sectional in-process view of a semiconductor structure that can be fabricated in accordance with one embodiment of the present invention;

Figure 6 is a fifth side elevation, cross-sectional in-process view of a semiconductor structure that can be fabricated in accordance with one embodiment of the present invention;

Figure 7 is a flow chart showing a process that can be utilized to fabricate the semiconductor structures shown in Figures 2 through 6;

Figure 8 is a side elevation, cross-sectional in-process view of a semiconductor structure that can be fabricated in accordance with a second embodiment of the present invention;

Figure 9 is a flow chart showing a process that can be utilized to fabricate the semiconductor structure shown in Figure 8;

Figure 10 is a side elevation, cross-sectional in-process view of a semiconductor structure that can be fabricated in accordance with a third embodiment of the present invention;

Figure 11 is a first side elevation, cross-sectional in-process view of a semiconductor structure that can be fabricated in accordance with a fourth embodiment of the present invention;

Figure 12 is a second side elevation, cross-sectional in-process view of a semiconductor structure that can be fabricated in accordance with a fourth embodiment of the present invention;

Figure 13 is a first side elevation, cross-sectional in-process view of a semiconductor structure that can be fabricated in accordance with a fifth embodiment of the present invention;

Figure 14 is a second side elevation, cross-sectional in-process view of a semiconductor structure that can be fabricated in accordance with a fifth embodiment of the present invention;

Figure 15 is a third side elevation, cross-sectional in-process view of a semiconductor structure that can be fabricated in accordance with a fifth embodiment of the present invention;

Figure 16 is a fourth side elevation, cross-sectional in-process view of a semiconductor structure that can be fabricated in accordance with a fifth embodiment of the present invention;

Figure 17 is a side elevation, cross-sectional in-process view of a semiconductor structure that can be fabricated in accordance with a sixth embodiment of the present invention;

Figure 18 is a side elevation, cross-sectional in-process view of a semiconductor structure that can be fabricated in accordance with a seventh embodiment of the present invention; and

Figure 19 is a side elevation, cross-sectional in-process view of a semiconductor structure that can be fabricated in accordance with an eighth embodiment of the present invention.

In accordance with common practice, the various described features are not drawn to scale but are drawn to emphasize specific features relevant to the exemplary embodiments.

### DETAILED DESCRIPTION

In the following detailed description, reference is made to the accompanying drawings that form a part hereof, and in which are shown by way of illustration specific illustrative embodiments. However, it is to be understood that other embodiments may be utilized and that logical, mechanical, and electrical changes may be made. Furthermore, the method presented in the drawing figures and the specification is not to be construed as limiting the order in which the individual acts may be performed. The following detailed description is, therefore, not to be construed in a limiting sense.

A variety of packaging and interconnection techniques are utilized to increase circuit density in semiconductor devices. For example, multi-chip modules (MCMs) are semiconductor structures that include multiple integrated circuits (ICs), semiconductor dies or chips, or discrete circuit components packaged on a single substrate. Stacked wafer packaging is a fabrication technique that stacks multiple semiconductor wafers or sections (e.g., dies or chips) in a vertical arrangement to provide a high density circuit package with a minimized footprint. Exemplary interconnection techniques utilized in high density circuit packages, such as MCMs and stacked wafer/die packages, include the formation of through-substrate vias (TSVs), controlled-collapse chip connections (CCCCs or C4s), and the like.

A consequence of increased circuit density is that the heat generated by the circuits is also increased. This increase in heat can cause the circuits to fail and/or their electrical performance to degrade. For example, the different coefficients of thermal expansion of the materials utilized in the layers of the circuit devices in a high density package can cause the layers to separate and the devices to fail. Also, the electrical performance of certain devices (e.g., matched devices, high power output devices, etc.) can be decreased and the devices can fail if the heat generated by additional circuits in a high density package is increased.

Embodiments of the present invention provide methods of forming a thermal conduction region in a semiconductor structure and structures resulting therefrom. The thermal conduction region provides a thermally-conductive path to remove heat from a surface of a semiconductor device, which increases the thermal dissipation performance of the semiconductor structure involved. Consequently, the increased thermal dissipation of the semiconductor structure can compensate for the increased heat generated by the additional circuits in high density packages such as, for example, MCMs and stacked wafer/die packages.

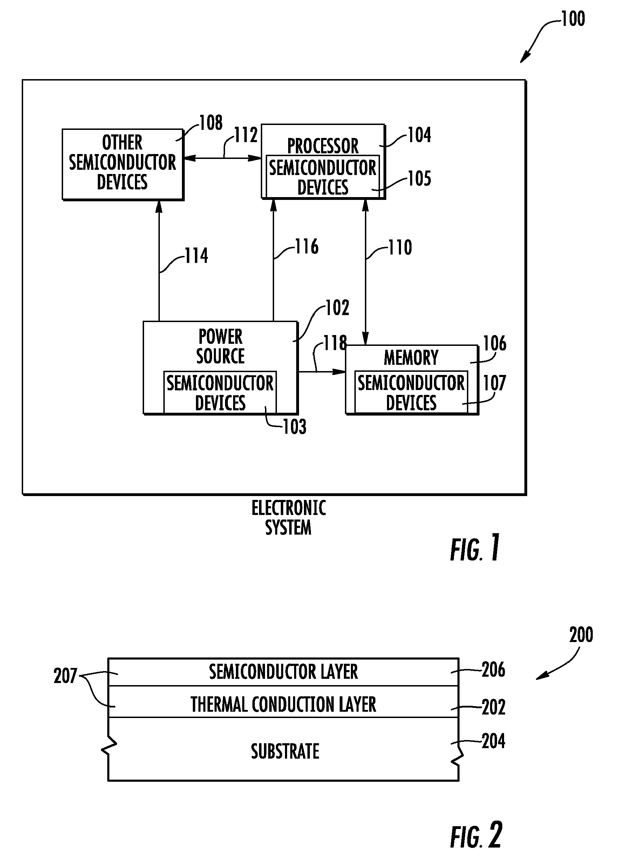

Figure 1 is a block diagram of an exemplary electronic system 100, which can be utilized to implement one or more embodiments of the present invention. In one embodiment, electronic system 100 includes a power source 102, a processor 104, a memory 106, and one or more other semiconductor devices 108. For example, the power source 102 can be a direct current (DC) power supply, power converter, power management system, battery-based power supply system, and the like. The processor 104 can be, for example, a microprocessor, microcontroller, embedded processor, digital signal processor, analog signal processor, data processor, light data processor, or a combination of the above. The memory 106 can be, for example, a static random access memory (SRAM), dynamic RAM (DRAM), read only memory (ROM), programmable ROM (PROM), flash memory, and the like. The other semiconductor devices 108 can be, for example, one or more integrated circuits (ICs), individual electronic circuits, electronic circuit components, or one or more electronic systems or subsystems that include a combination of the above. In any event, power source 102 provides operating power to the processor 104, memory 106, and other semiconductor devices 108 via the respective electrical conduction lines 116, 118, and 114. The processor 104 is coupled to the memory 106 and other semiconductor devices 108 via the respective data communication buses 110, 112 to provide data communications therebetween.

In one embodiment, each one of the power source 102, processor 104, and memory 106 includes a respective plurality of semiconductor devices 103, 105, and 107. Each one of the semiconductor devices 103, 105, 107, and 108 includes one or more ICs, individual electronic circuits, and/or electronic circuit components (e.g., transistors, resistors, capacitors), which are fabricated in accordance with at least one embodiment of the present invention, as described in more detail below.

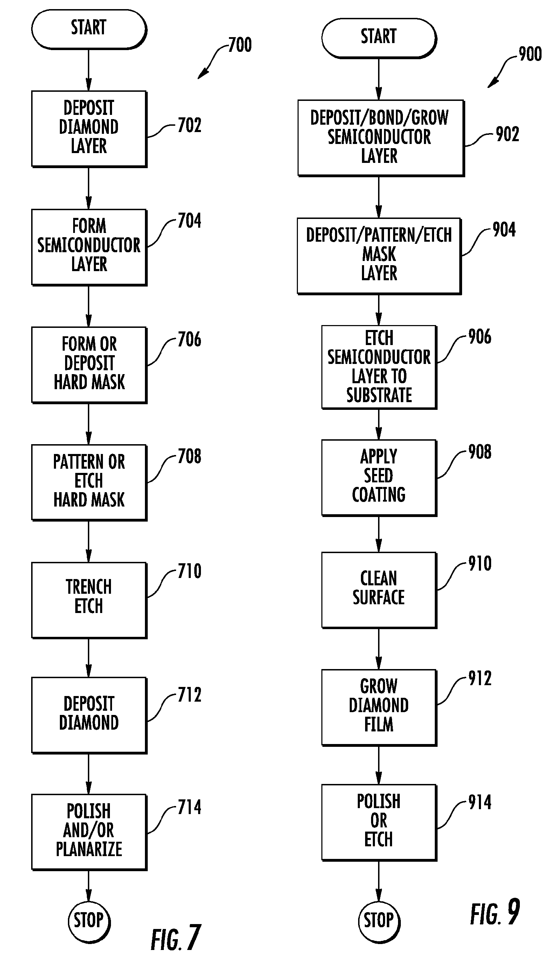

Figures 2 through 6 are related side elevation, cross-sectional in-process views of a semiconductor structure 200 that can be fabricated in accordance with one embodiment of the present invention. Figure 7 is a flow chart showing a process 700, which can be utilized to fabricate semiconductor structure 200 shown in Figures 2 through 6.

Referring to Figures 2 and 7, the first step (702) of the process flow shown is to utilize a suitable method to form (e.g., deposit) a thermal conduction layer on a semiconductor wafer or substrate, such as thermal conduction layer 202, and semiconductor substrate 204. For example, in one embodiment, the semiconductor substrate 204 can be a readily available silicon wafer, typically produced by cutting and polishing thin slices from a silicon crystal grown using the Czochralski process. The thickness of such wafers is typically in the range of 250 micrometers to 1,000 micrometers. The thermal conduction layer 202 can be a diamond film that ranges from 0.1 micrometer to 5 micrometers (e.g., approximately 1.5 micrometers) thick. Utilizing, for example, a chemical vapor deposition (CVD) process, such as Hot Filament CVD (HFCVD) or plasma-enhanced CVD (PECVD), the material (e.g., diamond) utilized for the thermal conduction layer 202 can be deposited on the semiconductor substrate 204 (e.g., at a temperature in the range from 700° C to 1000° C). Note that although a diamond material is utilized to form thermal conduction layer 202 in the exemplary embodiment shown, this selection is merely a design constraint and should not be considered a limitation of the present invention. For example, in another embodiment, a polycrystalline semiconductor material (e.g., silicon carbide) with an enhanced thermal conductivity similar to or not substantially lower than that of diamond can be utilized for thermal conduction layer 202. For example, the thermal conductivity of silicon carbide is approximately 120 watts/m K, and the thermal conductivity of diamond is in the range of 1,000 to 2,000 watts/m K.

Next, utilizing a suitable method (step 704), a semiconductor layer is formed (e.g., added onto) on the thermal conduction layer 202, such as semiconductor layer 206 shown in Figure 2. The method utilized to form semiconductor layer 206 can be, for example, a conventional wafer bonding step, which provides a single crystal semiconductor layer suitable for the formation of one or more semiconductor devices. For example, in one embodiment, semiconductor layer 206 can be a silicon material that is approximately 0.1 micrometer to 100 micrometers thick. In other embodiments, any suitable semiconductor material (e.g., Gallium Nitride, Gallium Arsenide, Indium Gallium Arsenide, Germanium, etc.) can be utilized for semiconductor layer 206, as long as the semiconductor material utilized can withstand the environmental conditions encountered during the bonding and subsequent processing steps. In the exemplary embodiment shown in Figure 2, the thermal conduction layer 202 and the semiconductor layer 206 form, for example, a silicon-on-diamond (SOD) substrate 207. In that regard, the semiconductor substrate 204 can be considered a "sacrificial" substrate, which can be utilized to facilitate the formation of the SOD substrate 207 and subsequently removed utilizing, for example, a chemical mechanical planarization (CMP) step. In some embodiments, and merely as a design choice (e.g., to minimize the number of process steps), the semiconductor substrate 204 can be retained.

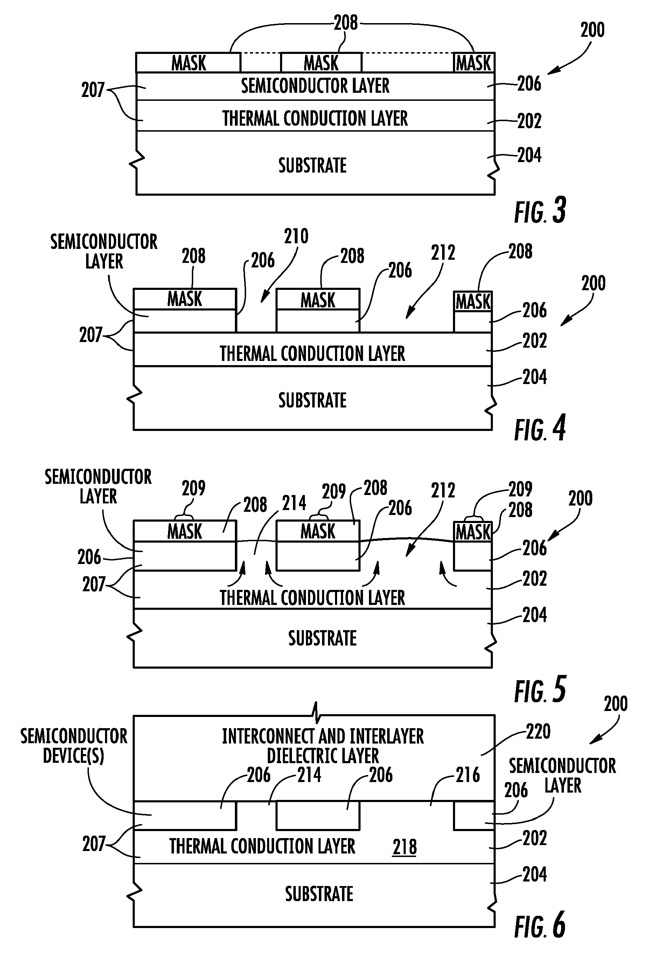

Referring to Figure 3, utilizing a suitable deposition method (step 706), a mask layer is formed (and subsequently patterned, as indicated by the dashed lines) on the semiconductor layer 206, such as mask layer 208. For example, in one embodiment, the mask layer 208 can be a photo-resist, which is deposited on the semiconductor layer 206 and patterned (e.g., as described below) to define an outline of one or more isolation regions (e.g., trenches, islands, vias) on the upper surface of the semiconductor layer 206. Note that the one or more isolation regions can be utilized to isolate a substrate from a device's interconnection and interlayer dielectric regions in a vertical direction, and also isolate separate portions of the semiconductor layer 206 from each other in a horizontal direction. In other embodiments, for example, the mask layer 208 can be an oxide material (e.g., silicon oxide), which is deposited or thermally-grown on the semiconductor layer 206. In still other embodiments, the mask layer 208 can be, for example, a combination of layers that includes one or more of the photo-resist and/or oxide materials described above. In yet another embodiment, one or more other suitable materials can be utilized for mask layer 208, such as, for example, silicon nitride or combinations of silicon nitride, silicon dioxide, and/or photo-resist materials.

Next, utilizing a suitable patterning and etching method (step 708), one or more areas of the mask layer 208 are etched to expose a predetermined pattern on the upper surface of semiconductor layer 206. For example, if mask layer 208 is composed of a silicon dioxide material, mask layer 208 can be patterned and etched utilizing an oxide etch to define and expose a predetermined layout of one or more isolation regions (e.g., trenches, islands, vias) to be formed in a subsequent process step.

Referring to Figure 4, utilizing a suitable etching method (step 710), the exposed areas on the semiconductor layer 206 are then etched down to the surface of the underlying thermal conduction layer 202 to form one or more isolation regions (e.g., trenches), such as first isolation region 210 and second isolation region 212. For example, the first isolation region 210 and the second isolation region 212 can be formed utilizing an isotropic plasma etch followed by a reactive ion etch. Note that this side elevation view appears to show discontinuous isolation regions 210, 212. However, a top down view (i.e., looking downward at the upper surface of mask layer 208) would show that the isolation regions 210, 212 are actually segments of a continuous isolation region that surrounds the separate portions of the semiconductor layer 206 and thereby defines isolated semiconductor "islands". In any event, note that if an inorganic material (e.g., not photo-resist because it is an organic material) is utilized to form the mask layer 208, the mask material that remains after the etching step (710) can be retained on the semiconductor layer 206 or removed in a subsequent process step.

Referring to Figure 5, utilizing a suitable deposition method (step 712), the material utilized for the thermal conduction layer 202 can be grown in the isolation regions 210, 212 to form one or more thermal conduction regions, such as first thermal conduction region 214 and second thermal conduction region 216. For example, in one embodiment, a suitable (e.g., diamond) refill process can be utilized to selectively grow a polycrystalline (e.g., diamond) film in each isolation region 210, 212. Note that this side elevation view appears to show discontinuous thermal conduction regions 214, 216. However, a top down view (i.e., looking downward at the upper surface of mask layer 208) would show that the thermal conduction regions 214, 216 are actually segments of a continuous thermal conduction region that surrounds the separate portions (e.g., isolated islands) of the semiconductor layer 206.

In any event, utilizing the above-described refill process, the nanometer-sized or micrometer-sized crystals of the crystalline (e.g., diamond) material at the upper surface of the thermal conduction layer 202 provide nucleation sites to facilitate crystal growth in the isolation regions 210, 212. Utilizing, for example, a suitable deposition process, such as HFCVD, PECVD, or HF decomposition of methane, at a temperature in the range from 700° C to 1000° C (e.g., approximately 700° C), a polycrystalline (e.g., diamond) material is grown outward from the nucleating sites and utilized to fill in and thereby form the first thermal conduction region 214 and the second thermal conduction region 216. Note that the polycrystalline (e.g., diamond) material utilized to form the first and second thermal conduction regions 214, 216 is self-aligned, in the sense that the nucleation sites at the surface of the thermal conduction layer 202 function to confine the growth of the polycrystalline material to the first and second isolation regions 210, 212. However, as indicated in Figure 5, a small, random number of crystalline regions 209 may be formed by spurious nucleation on the upper surface of the mask layer 208. Nevertheless, the crystalline material in the regions 209 can be removed with a subsequent polishing and etching (e.g., planarization) step.

Note that, in the embodiment shown in Figure 6, the first and second thermal conduction regions 214, 216 appear to have different widths. In another embodiment, the widths of the thermal conduction regions 214, 216 can be the same. However, some types of refill processes may benefit if the widths of the thermal conduction regions utilized are the same. For example, it is beneficial to utilize uniform widths for two or more thermal conduction regions if the crystal nucleation is to occur on the sidewalls rather than the bottoms of the isolation regions (e.g., trenches) involved.

In any event, the thermal conduction layer 202 and the thermally-conductive crystalline material grown in the first and second thermal conduction regions 214, 216 form a thermally-conductive region 218 that can dissipate heat generated by a semiconductor device formed in the depicted portions of the semiconductor layer 206 of the SOD substrate 207, along with backend processing regions such as, for example, the interconnection and interlayer dielectric layer 220 shown in Figure 6. The interconnection and interlayer dielectric layer 220 can include, for example, interconnect layers, dielectric layers, and passive components (e.g., thin film resistors). As such, a semiconductor device composed of the material (e.g., silicon) in one or more portions of semiconductor layer 206 and the materials utilized in the interconnection and interlayer dielectric layer 220 can be an IC, analog or digital circuit, or one or more circuit components (e.g., transistor, resistor, etc.) formed in a subsequent fabrication process flow.

Utilizing a suitable polishing and/or planarization method (step 714), the upper surface of the semiconductor structure 200 can be treated in preparation for additional fabrication processing. For example, in one embodiment, a CMP or etching method can be utilized to smooth and planarize the upper surface of the SOD substrate 207, so that the semiconductor devices formed in the semiconductor layer portions 206 and the interconnection and interlayer dielectric layer 220 can be formed on the SOD substrate 207 in a subsequent process flow.

Note that if the above-described process 700 is utilized to form one or more thermal conduction regions utilizing the above-described trench isolation and diamond refill processes, the embodiments shown in Figures 2 through 6 can be considered either "trench before device" (e.g., transistor, resistor, etc.) or "trench after device" fabrication processes. In other words, the embodiments shown in Figures 2 through 6 can be fabricated either before or after a semiconductor device is fabricated. However, in any event, either of these processes can be readily integrated into the overall process of fabricating a semiconductor device, as long as these processes are performed before any wafer processing is performed that can be harmed by the thermally-conductive polycrystalline (e.g., diamond) growth conditions involved (e.g., temperatures greater than 700° C). However, the actual integration point of such (e.g., trench) isolation and (e.g., diamond) refill processes can occur later in the device fabrication process as the state-of-the-art is improved for diamond film growth or back-end-of-line (BEOL) processes, such as the processes utilized to form interconnection metals, contacts, vias, and the like. For example, the realization of diamond deposition temperatures that are much lower than 700° C, or the utilization of higher temperature BEOL metals (e.g., refractory metals), will enhance integration flexibility in future semiconductor device fabrication process flows.

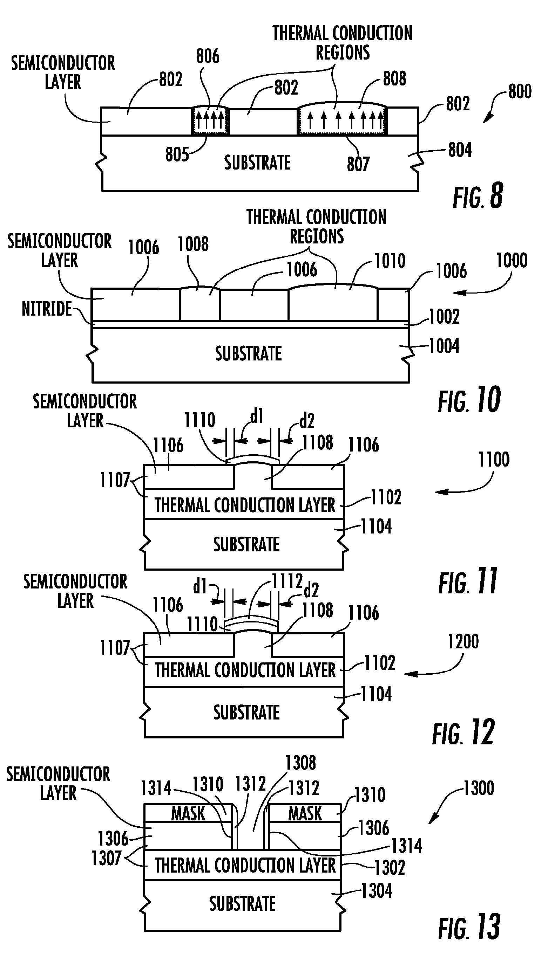

Figure 8 is a side elevation, cross-sectional in-process view of a semiconductor structure 800 that can be fabricated in accordance with a second embodiment of the present invention. Figure 9 is a flow chart showing a process 900, which can be utilized to fabricate semiconductor structure 800 shown in Figure 8. Note that, in this embodiment, process 900 provides a more generic (e.g., diamond trench) refill fabrication approach, which takes advantage of differences in the likelihood of (e.g., diamond) crystal nucleation on various materials to form a thermal conduction region in a semiconductor structure. Also in this embodiment, process 900 provides a fabrication approach that utilizes a crystalline (e.g., diamond) "seed" layer to form nucleation sites that facilitate the formation of a thermal conduction region in a semiconductor structure.

Referring to Figures 8 and 9, the first step (902) of the process flow shown is to utilize a suitable method to form (e.g., deposit, bond, or grow) a semiconductor layer on a starting substrate, such as semiconductor layer 802 and substrate 804. For example, in one embodiment, a semiconductor layer 802 of a silicon material can be formed on a diamond substrate 804 utilizing a conventional semiconductor deposition, bonding, or growing method. The thickness of the silicon layer 802 can be in the range of 0.1 micrometer to 100 micrometers and depends on the particular semiconductor technology being utilized. In a different embodiment, both layer 802 and substrate 804 can formed utilizing a semiconductor material, and layer 802 can be, for example, epitaxially grown on substrate 804. Note that other combinations of suitable (e.g., semiconductor and/or thermally-conductive crystalline) materials can be utilized to form layer 802 and substrate 804, as long as the material utilized to form layer 802 is suitable for the semiconductor device fabrication process to be performed.

Next, a suitable deposition, patterning and etching (e.g., photo-resist) method (step 904) is utilized to define and form one or more isolation regions (e.g., trenches, islands, vias) in the semiconductor layer 802, such as first isolation region 806 and second isolation region 808. For example, in one embodiment, the first and second isolation regions 806, 808 can be formed in accordance with the steps of process 700 described above, which were utilized to form the mask layer 208 and the isolation regions 210, 212 in Figure 4. However, in the embodiment shown in Figure 8, the depth of the first and second isolation regions 806, 808 is determined by the thickness of the semiconductor layer 802. Note that this side elevation view appears to show discontinuous isolation regions 806, 808. However, a top down view (i.e., looking downward at the upper surface of semiconductor layer 802) would show that the isolation regions 806, 808 are actually segments of a continuous isolation region that surrounds the separate portions of the semiconductor layer 802 and thereby defines isolated semiconductor "islands".

Next, utilizing a suitable (e.g., trench) etching method (step 906), the areas defined by the mask pattern on the semiconductor layer are etched down to the substrate 804. Utilizing a suitable application method (step 908), a thin coating of the thermal conduction (e.g., diamond) material is then applied to the upper surface of semiconductor structure 800. For example, in one embodiment, a suspension or slurry containing individual (e.g., diamond) crystals is applied to the upper surface of semiconductor structure 800 and the exposed surfaces (bottoms and sidewalls) of the first and second isolation regions 806, 808. The suspension contains individual micrometer- or nanometer-sized (e.g., diamond) crystals in a solvent carrier. Utilizing a suitable cleaning method (step 910), the upper surface of the semiconductor structure 800 is then cleaned to remove the crystalline (e.g., diamond) material that was previously applied. However, the cleaning method utilized leaves a layer of individual crystals 805, 807 on the bottom and sidewall surfaces of the first and second isolation regions 806, 808. The individual crystals in layers 805, 807 function as "seed crystals" or nucleation sites to facilitate crystal growth in the first and second isolation regions 806, 808.

A suitable deposition method (step 912) is then utilized to selectively grow a thermally-conductive, polycrystalline (e.g., diamond) film in the first and second isolation regions 806, 808. For example, utilizing a suitable deposition process, such as HFCVD, PECVD, or HF decomposition of methane, at a temperature in the range from 700° C to 1000° C (e.g., approximately 700° C), a polycrystalline (e.g., diamond) material is grown outward from the nucleating sites and utilized to fill in the first isolation 806 and the second isolation region 808. Note that the polycrystalline (e.g., diamond) material utilized to fill in the first and second isolation regions 806, 808 is self-aligned, in the sense that the nucleation sites on the bottom and sidewall surfaces of the first and second isolation regions 806, 808 function to confine the growth of the polycrystalline (e.g., diamond) material to the first and second isolation regions 806, 808. Next, utilizing a suitable polishing or etching method (914), each of the first and second isolation regions 806, 808 can form, for example, a diamond damascene. The process of forming a diamond damascene can be utilized to create individual diamond "islands" in a semiconductor device, which can be utilized to form one or more heat pipes, diamond-based semiconductor devices, interconnects, and the like. In any event, note that the thermally-conductive (e.g., diamond) film or damascene formed in each isolation region 806, 808 creates a thermal conduction path from the upper surface of semiconductor structure 800 to the substrate 804, and the semiconductor layer portions 802 are also isolated (e.g., from each other) in the horizontal direction by the diamond material grown in the first and second isolation regions 806, 808. For example, such a diamond film or damascene structure can be utilized to form a heat sink. Also, if the (e.g., diamond) nucleation properties of the materials utilized in the substrate 804 and semiconductor layer 802 are known, these materials can be selected to enhance (e.g., diamond) crystal nucleation on the substrate regions (e.g., the bottom surface of each isolation region 806, 808), while inhibiting crystal nucleation on the semiconductor layer 802 (e.g., the exposed upper surfaces of semiconductor layer 802) and the sidewall surfaces of isolation regions 806, 808.

Figure 10 is a side elevation, cross-sectional in-process view of a semiconductor structure 1000 that can be fabricated in accordance with a third embodiment of the present invention. Essentially, except for one additional step (described below), the steps utilized above in process 900 to form semiconductor structure 800 can also be utilized to form semiconductor structure 1000 shown in Figure 10. However, in the embodiment shown in Figure 10, an isolation layer 1002 is formed on a starting substrate 1004, and a semiconductor layer 1006 is formed on the isolation layer 1002. For example, in one embodiment, the isolation layer 1002 is a nitride (e.g., silicon nitride) material, and the semiconductor layer 1006 is a silicon material. In this embodiment, the materials are pre-selected so that the diamond trench refill crystals preferentially nucleate on the surfaces of the isolation (e.g., nitride) layer 1002 (exposed after the trench etch step), but not on the exposed surfaces of the semiconductor (e.g., silicon) layer 1006. In any event, note that the thermally-conductive crystalline (e.g., diamond) film subsequently formed in each isolation region 1008, 1010 creates a thermal conduction path to the upper surface of the semiconductor structure 1000. Also note that the thermally-conductive crystalline film in each isolation region 1008, 1010 provides isolation from the starting substrate 1004 in a vertical direction, and also isolates the separate portions of the semiconductor layer 1006 (e.g., from each other) in a horizontal direction. Similar to the embodiment shown in Figure 8, the embodiment shown in Figure 10 also takes advantage of the likelihood of (e.g., diamond) crystal nucleation on the isolation layer 1002 and the semiconductor layer 1006, by selecting a suitable material (e.g., nitride) for the isolation layer 1002 that enhances crystal nucleation, and selecting a suitable material (e.g., silicon) for the semiconductor layer 1006 that inhibits crystal nucleation.

Diamond materials can burn if they are exposed to oxygen at temperatures greater than 700° C. Consequently, if diamond (or a material with similar combustion properties) is utilized in a "trench before device" fabrication process, integration issues can arise that limit the use of certain materials or process environments in subsequent fabrication processes that utilize temperatures of 700° C or greater.

Embodiments of the present invention provide methods of protecting a thermal conduction region in a semiconductor structure and structures resulting therefrom. Specifically, Figures 11 and 12 are related side elevation, cross-sectional in-process views of a semiconductor structure 1100 that can be fabricated in accordance with a fourth embodiment of the present invention. Essentially, in the embodiment shown in Figure 11, a suitable isolation material (e.g., silicon nitride) is utilized as a "cap" to protect the integrity of the crystalline (e.g., diamond) material in a thermal conduction region during a subsequent semiconductor fabrication process, such as, for example, the process of forming, growing and/or depositing an insulator layer utilizing an oxide material. The isolation material of the "cap" forms an effective barrier to oxidation and/or diffusion of oxygen into the crystalline (e.g., diamond) material in the thermal conduction region involved.

Referring to Figure 11, note that as a starting point, a semiconductor structure including a thermal conduction region 1108 can be formed utilizing the steps of processes 700 or 900 described above. For example, in the embodiment shown in Figure 11, a thermally-conductive crystalline (e.g., diamond) layer 1102 is formed on a substrate 1104, and a semiconductor (e.g., silicon) layer 1106 is formed on the crystalline layer 1102. The semiconductor layer 1106 is patterned and etched to form the thermal conduction region 1108 into which an additional crystalline (e.g., diamond) material is selectively grown. A protective layer 1110 or "cap" is then formed on the upper surface of the thermal conduction region 1108 and a portion of the semiconductor layer 1106. For example, in one embodiment, a layer of a nitride (e.g., silicon nitride) material can be deposited on the upper surface of the thermal conduction region 1108, by reacting dichlorosilane with ammonia at approximately 800° C. A nitride material is preferable for protective layer 1110, because nitrides are materials that are impervious to oxygen and also do not contain oxygen that can migrate into the crystalline (e.g., diamond) material in the thermal conduction region 1108. Also, a nitride material can deter the diffusion of carbon from a diamond-based thermal conduction region 1108 into the semiconductor layer 1106.

The dimensions d₁ and d₂ shown in Figure 11 represent the amount of overlap spacing that the protective layer 1110 provides to cover the surface of the semiconductor layer 1106. Typically, the values of the overlap dimensions d₁, d₂ can be equal. Nevertheless, the values selected for the overlap dimensions d₁ and d₂ should be large enough to minimize the potential for oxidation of the crystalline material in the thermal conduction region 1108. For example, an oxidation of the crystalline material in the thermal conduction region 1108 can by caused by an erosion of the interface between the protective layer 1110 and the semiconductor layer 1106 during a subsequent fabrication step wherein an oxide (e.g., field oxide, trench oxide, ion implantation mask oxide, gate oxide, capacitor oxide, etc.) is being formed. A structure that can form as a result of erosion of such an interface in a semiconductor device is commonly referred to as a "bird's beak" formation.

In the embodiment shown in Figure 12, a protective layer or "cap" is composed of two layers of protective materials, which are utilized to protect the integrity of the crystalline (e.g., diamond) material in the thermal conduction region 1108. The composite protective layer includes a first layer 1110 of an insulator (e.g., silicon dioxide) material deposited (e.g., utilizing a PECVD of TEOS at approximately 400° C) on the upper surface of the thermal conduction region 1108. For example, the first layer 1110 can be approximately 650 Angstroms thick. The composite protective layer also includes a second layer 1112 of a material (e.g., silicon nitride) that is impervious to oxygen, which is deposited (e.g., by CVD) on the first layer 1110. Again, the values of the overlap dimensions d₁, d₂ can be equal. However, in any event, the values selected for the dimensions d₁ and d₂ should be large enough to minimize the potential for oxidation of the crystalline material in the thermal conduction region 1108. Also, the material (e.g., silicon oxide) utilized for the first layer 1110 should be silicon-rich to minimize the amount of oxygen in the first layer 1110 and avoid reactions of the oxygen in the first layer 1110 with the crystalline material in the thermal conduction region 1108.

In a different embodiment, the composite protective layer shown in Figure 11 can include a first layer 1110 of an insulator (e.g., silicon dioxide) material deposited on the upper surface of the thermal conduction region 1108, and a second layer 1112 of a semiconductor (e.g., polysilicon) material deposited on the first layer 1110. However, in this embodiment, the polysilicon material utilized in the second layer 1112 is less desirable than a nitride material, because polysilicon is an electrically-conductive material. Consequently, a polysilicon second layer 1112 can form a potential voltage breakdown path between the silicon "device islands" in the portions of the semiconductor layer 1106 shown. Also, similar to the other embodiment shown in Figure 11, the values selected for the overlap dimensions d₁ and d₂ have to be large enough to minimize the potential for oxidation of the crystalline material in the thermal conduction region 1108, as described above.

In a semiconductor fabrication process that utilizes a refill process to form a thermal conduction region in an isolation region (e.g., trench) with a thermally-conductive crystalline material (e.g., diamond), such as, for example, the embodiment shown in Figures 2 through 6, the thermally-conductive crystalline material can form nucleation sites on the sidewall surfaces of the isolation region if these surfaces are not smooth enough. These nucleation sites on the sidewall surfaces of an isolation region hinder, rather than facilitate, the crystalline growth process utilized to form the thermal conduction region. Embodiments of the present invention provide a "liner" or layer of a spacer material on the sidewall surfaces of an isolation region. The "liner" minimizes the formation of crystal nucleation sites on the sidewall surfaces of the isolation region, as described in the embodiments below.

Specifically, Figures 13 through 16 are related side elevation, cross-sectional in-process views of a semiconductor structure 1300 that can be fabricated in accordance with a fifth embodiment of the present invention. Essentially, for the embodiment shown, the semiconductor structure 1300 can be fabricated in accordance with the above-described, exemplary process 700 that is utilized to form the semiconductor structure 200 in Figures 2 through 6. However, in the embodiment shown in Figures 13 through 16, the process is further utilized to form a "liner" on the sidewall surfaces of an isolation region, whereby the process can begin after the isolation region (e.g., trench) is formed utilizing, for example, an etching step.

For example, referring to Figure 13, semiconductor structure 1300 includes a thermal conduction (e.g., diamond) layer 1302 on a semiconductor (e.g., silicon) wafer or substrate 1304, a semiconductor (e.g., silicon) layer 1306 on the thermal conduction layer 1302, and a mask layer 1310 on the semiconductor layer 1306. The mask layer 1310 is patterned and etched, and then semiconductor layer 1306 is etched downward to the surface of the thermal conduction layer 1302 to form an isolation region 1308. In the embodiment shown, the thermal conduction layer 1302 and the semiconductor layer 1306 form a SOD substrate 1307.

At this point, a first spacer layer 1312 (e.g., "liner") is formed on the sidewall surfaces 1314 of the isolation region 1308 utilizing, for example, an insulator (e.g., silicon oxide) material. For example, a suitable spacer etch method can be utilized to form the first spacer layer 1312 and also ensure that the crystalline (e.g., diamond) material at the upper surface of the thermal conduction layer 1302 remains exposed in the isolation region 1308. In some embodiments, the first spacer layer 1312 can be formed utilizing, for example, a nitride material, polysilicon material, or a composite made of oxide, nitride, and/or polysilicon materials. In any event, the thickness of the first spacer layer 1312 is selected to ensure that a polysilicon "cap" formed in a subsequent step does not create an electrical short between the (e.g., silicon) device "islands" or separate portions of semiconductor layer 1306.

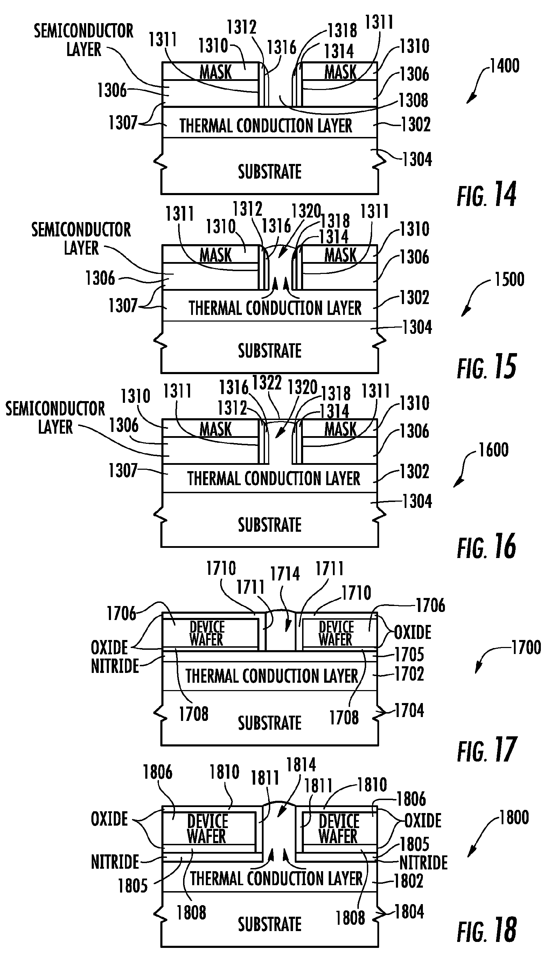

The same spacer etch method can also be utilized to form a second spacer layer on the first spacer layer 1312 (or 1314) that was formed on the sidewalls 1311, such as the second spacer layer 1316 (or 1318) shown in Figure 14. For example, the second spacer layer 1316 can be formed utilizing a semiconductor (e.g., polysilicon) material. Again, the spacer etch method utilized to form the second spacer layer 1316 (or 1318) should ensure that the crystalline (e.g., diamond) material at the upper surface of the thermal conduction layer 1320 (described below) remains exposed in the isolation region 1308. Note that if an oxide material is utilized for the first spacer layer 1312 (or 1314), the first spacer layer 1312 can form an oxidation path to the interface with the crystalline (e.g., diamond) material utilized in the isolation region 1308. Consequently, the second spacer layer 1316 forms an effective oxidation barrier between the first spacer layer 1312 and the crystalline material utilized in the isolation region 1308 to form a thermal conduction region, such as the thermal conduction region 1320 shown in Figure 15. As such, the spacer etch methods utilized to form the first and second spacer layers 1312, 1316 ensure that nucleation sites are not formed on the sidewalls 1311 of the isolation region 1308.

Referring to Figure 16, a suitable deposition method is utilized to form a semiconductor (e.g., polysilicon) cap 1322 on the thermal conduction region 1320. The upper surface of the semiconductor structure can then be planarized by utilizing, for example, a CMP method. Consequently, as shown in Figure 16, the thermal conduction region 1320 is enclosed and thus isolated by the semiconductor (e.g., polysilicon) materials utilized for the second spacer layer 1316 (or 1318) and the cap 1322. In this case, the original mask layer 1310 is retained so that the material utilized for the cap 1322 will not form an electrical connection between the separate portions of the isolation region 1308.

Figure 17 is a side elevation, cross-sectional view of a semiconductor structure 1700 that can be fabricated in accordance with a sixth embodiment of the present invention. Referring to Figure 17, the semiconductor structure 1700 includes a first thermal conduction (e.g., diamond) layer 1702 on a semiconductor (e.g., silicon) wafer or substrate 1704, and a second thermal conduction, oxygen-impervious (e.g., nitride) layer 1705 on the first thermal conduction layer 1702. In one embodiment, the first thermal conduction layer 1702 is approximately 1.5 micrometers thick, and the second thermal conduction layer 1705 is approximately 1,200 Angstroms thick.

The semiconductor structure 1700 also includes a first insulation (e.g., oxide) layer 1708 on the second thermal conduction layer 1705, and a semiconductor (e.g., silicon) device layer 1706 on the first insulation layer 1708. Semiconductor structure 1700 also includes a second insulation (e.g., oxide) layer 1710 on the semiconductor device layer 1706 and the sidewalls 1711 of a thermal conduction (e.g., diamond) region 1714. In one embodiment, each of the first insulation layer 1708 and the second insulation layer 1710 is approximately 650 Angstroms thick. In the embodiment shown in Figure 17, the thermal conduction region 1714 is formed utilizing an applied layer of "seed" crystals that form nucleation sites for the thermally-conductive, polycrystalline (e.g., diamond) material to be formed. Note that the thermal conduction region 1714 is horizontally and vertically isolated from the semiconductor device layer 1706 by the insulation layers 1708, 1710, 1711.

Note that the second thermal conduction layer 1705 has at least two beneficial functions in the embodiment shown. For example, the second thermal conduction layer 1705 utilizes a material (e.g., nitride) that facilitates, rather than inhibits, nucleation of the thermally-conductive polycrystalline (e.g., diamond) utilized in the thermal conduction region 1714. Also, the material (e.g., nitride) utilized effectively encapsulates and protects the thermally-conductive polycrystalline (e.g., diamond) material from certain environmental conditions. For example, if a diamond material is formed in a thermal conduction region utilizing an HF deposition process, the resulting diamond material includes a significant amount of Tungsten derived from the deposition process. If the second thermal conduction layer 1705 utilizes a nitride material, the nitride material effectively keeps the Tungsten away from the silicon in the device layer 1706.

Figure 18 is a side elevation, cross-sectional view of a semiconductor structure 1800 that can be fabricated in accordance with a seventh embodiment of the present invention. Referring to Figure 18, the semiconductor structure 1800 includes a first thermal conduction (e.g., diamond) layer 1802 on a semiconductor (e.g., silicon) wafer or substrate 1804, and a second thermal conduction, oxygen-impervious (e.g., nitride) layer 1805 on the first thermal conduction layer 1802. In one embodiment, the first thermal conduction layer 1802 is approximately 1.5 micrometers thick, and the second thermal conduction layer 1805 is approximately 1,200 Angstroms thick.

The semiconductor structure 1800 also includes a first insulation (e.g., oxide) layer 1808 on the second thermal conduction layer 1805, a semiconductor (e.g., silicon) device layer 1806 on the first insulation layer 1808, and a second insulation (e.g., oxide) layer 1810 on the semiconductor device layer 1806 and also on the sidewalls 1811 of a thermal conduction (e.g., diamond) region 1814. In one embodiment, each of the first insulation layer 1808 and the second insulation layer 1810 is approximately 650 Angstroms thick. Note that the thermal conduction region 1814 is horizontally and vertically isolated from the semiconductor device layer 1806 by the insulation layers 1808, 1810, 1811. Also note that the thermal conduction region 1814 is formed utilizing the crystals at the surface of the first thermal conduction layer 1802 as "seed" crystals to form the nucleation sites for the thermally-conductive, polycrystalline (e.g., diamond) material to be grown in the thermal conduction region 1814.

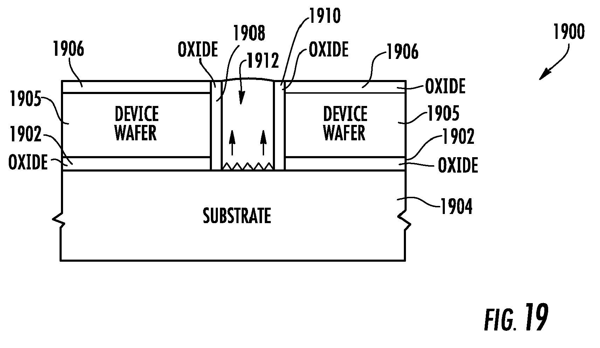

Figure 19 is a side elevation, cross-sectional view of a semiconductor structure 1900 that can be fabricated in accordance with an eighth embodiment of the present invention. Referring to Figure 19, the semiconductor structure 1900 includes a first insulation (e.g., oxide) layer 1902 on a semiconductor (e.g., silicon) wafer or substrate 1904, a second insulation (e.g., oxide) layer 1906 on portions of a semiconductor device wafer 1905, and a third insulation (e.g., oxide) layer 1908 (or 1910) on the sidewalls of a thermal conduction region 1912. The portions of the semiconductor device wafer 1905 are formed on portions of the first insulation layer 1902. In one embodiment, each of the first insulation layer 1902, the second insulation layer 1906, and the third insulation layer 1908 (or 1910) is approximately 650 Angstroms thick.

In the embodiment shown in Figure 19, the thermal conduction region 1912 is formed utilizing an applied layer of "seed" crystals that form nucleation sites for the thermally-conductive, polycrystalline (e.g., diamond) material to be formed. Also note that the thermal conduction region 1912 is horizontally and vertically isolated from the semiconductor device wafer 1905 by the first, second, and third insulation layers 1902, 1906, and 1908 (or 1910). As such, the primary isolation for the thermal conduction region 1912 is provided by the third insulation layer 1908 (and 1910). Note that for the embodiment shown in Figure 19, the thermal conduction region 1912 is formed directly on the semiconductor wafer or substrate 1904 with no thermally-conductive (e.g., nitride) isolation layer interposed therebetween.

In the discussion and claims herein, the term "on" used with respect to two materials, one "on" the other, means at least some contact between the materials, while "over" means the materials are in proximity, but possibly with one or more additional intervening materials such that contact is possible but not required. Neither "on" nor "over" implies any directionality as used herein. The term "conformal" describes a coating material in which angles of the underlying material are preserved by the conformal material. The term "about" indicates that the value listed may be somewhat altered, as long as the alteration does not result in nonconformance of the process or structure to the illustrated embodiment.

Terms of relative position as used in this application are defined based on a plane parallel to the conventional plane or working surface of a wafer or substrate, regardless of the orientation of the wafer or substrate. The term "horizontal" or "lateral" as used in this application is defined as a plane parallel to the conventional plane or working surface of a wafer or substrate, regardless of the orientation of the wafer or substrate. The term "vertical" refers to a direction perpendicular to the horizontal. Terms such as "on," "side" (as in "sidewall"), "higher," "lower," "over," "top," and "under" are defined with respect to the conventional plane or working surface being on the top surface of the wafer or substrate, regardless of the orientation of the wafer or substrate.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that the present invention be limited only by the claims and the equivalents thereof.

A further method of manufacture of a semiconductor structure of the invention comprises forming a semiconductor layer over a thermal conduction layer; forming an isolation region over the thermal conduction layer; and forming a thermal conduction region in the isolation region.
Preferably, the method of the invention comprises forming of the thermal conduction layer over a semiconductor wafer or substrate.
Preferably, in the method of the invention the forming of the thermal conduction region comprises at least one of depositing and growing a thermally-conductive semiconductor crystalline material in the isolation region.
Preferably, in the method of the invention the forming of the thermal conduction region comprises at least one of depositing and growing a diamond film in the isolation region.
Preferably, in the method of the invention the forming of the semiconductor layer over the thermal conduction layer comprises forming a silicon on diamond (SOD) substrate.
Preferably, in the method of the invention the forming of the isolation region comprises forming a trench in the semiconductor layer.
Preferably, in the method of the invention the forming of the isolation region further comprises forming a first isolation layer on a sidewall of the isolation region.
Preferably, the method of the invention comprises forming of a second isolation layer on the thermal conduction region.
Preferably, the method of the invention comprises forming of a semiconductor device over the thermal conduction region.
Preferably, in the method of the invention the forming of the isolation region comprises forming a mask on the semiconductor layer; patterning the mask; etching the mask; and etching the semiconductor layer.

A further method of manufacture of a semiconductor structure of the invention comprises forming a semiconductor layer; forming an insulation layer over the semiconductor layer; forming an isolation region in the insulation layer; and growing a thermally-conductive crystalline material in the isolation region.
Preferably, the method of the invention comprises forming of an isolation layer between the semiconductor layer and the insulation layer.
Preferably, the method of the invention comprises forming an isolation layer between the semiconductor layer and the insulation layer; forming a second semiconductor layer over the insulation layer; forming a second insulation layer over the second semiconductor layer; and forming a third insulation layer on a sidewall of the isolation region.

A further method of manufacture of a semiconductor structure of the inventions comprises depositing a first layer of a thermally-conductive crystalline material on a semiconductor wafer or substrate; depositing a layer of a semiconductor material on the first layer of the thermally-conductive crystalline material; depositing a layer of a mask material on the layer of the semiconductor material; forming a pattern on the layer of the mask material; etching the pattern on the layer of the mask material; etching the layer of the semiconductor material in accordance with the pattern and thereby forming an isolation region; and depositing a second layer of the thermally-conductive crystalline material in the isolation region.
Preferably, in the method of the invention the depositing a first layer of a thermally-conductive material comprises depositing a layer of a diamond material.
Preferably, in the method of the invention the depositing a layer of a mask material comprises forming a layer of an oxide material.
Preferably, in the method of the invention the depositing a layer of a mask material comprises forming a hard mask.
Preferably, in the method of the invention the forming of an isolation region comprises etching a trench.
Preferably, in the method of the invention the depositing a second layer of the thermally-conductive crystalline material comprises depositing a second layer of a diamond material.

A further method of manufacture of a semiconductor structure of the invention comprises depositing an oxide layer; forming a pattern on the oxide layer; etching the pattern on the oxide layer and thereby forming an isolation region; applying a crystal seed coating to a surface of the oxide layer and a surface of the isolation region; cleaning the surface of the oxide layer; and growing a thermally-conductive polycrystalline film from the crystal seed coating on the surface of the isolation region.
Preferably, in the method of the invention the depositing the oxide layer comprises depositing a layer of a silicon oxide material on a silicon substrate.
Preferably, in the method of the invention the applying comprises forming a plurality of diamond crystal nucleation sites on at least a bottom surface of a trench.
Preferably, in the method of the invention the growing comprises forming at least one of a diamond film and a diamond damascene.
Preferably, in the method of the invention the semiconductor structure comprises a semiconductor device.
Preferably, the method of the invention comprises forming a first spacer layer on a sidewall surface of the isolation region; and forming a second spacer layer on the thermally-conductive polycrystalline film.

## Claims

1. A method of manufacture of a semiconductor structure, comprising:
forming a semiconductor layer over a thermal conduction layer;
forming an isolation region over the thermal conduction layer; and
forming a thermal conduction region in the isolation region.

2. The method of claim 1, further comprising forming the thermal conduction layer over a semiconductor wafer or substrate.

3. The method of claim 1, wherein the forming the thermal conduction region comprises at least one of depositing and growing a thermally-conductive semiconductor crystalline material in the isolation region.

4. The method of claim 1, wherein the forming the thermal conduction region comprises at least one of depositing and growing a diamond film in the isolation region.

5. The method of claim 1, wherein the forming the semiconductor layer over the thermal conduction layer comprises forming a silicon on diamond (SOD) substrate.

6. The method of claim 1, wherein the forming the isolation region comprises forming a trench in the semiconductor layer.

7. The method of claim 1, wherein the forming the isolation region further comprises forming a first isolation layer on a sidewall of the isolation region.

8. The method of claim 1, further comprising forming a second isolation layer on the thermal conduction region.

9. The method of claim 1, further comprising forming a semiconductor device over the thermal conduction region.

10. The method of claim 1, wherein the forming the isolation region comprises:
forming a mask on the semiconductor layer;
patterning the mask;
etching the mask; and
etching the semiconductor layer.

11. A method of manufacture of a semiconductor structure, comprising:
forming a semiconductor layer;
forming an insulation layer over the semiconductor layer;
forming an isolation region in the insulation layer; and
growing a thermally-conductive crystalline material in the isolation region.

12. The method of claim 11, further comprising forming an isolation layer between the semiconductor layer and the insulation layer.

13. The method of claim 11, further comprising:
forming an isolation layer between the semiconductor layer and the insulation layer;
forming a second semiconductor layer over the insulation layer;
forming a second insulation layer over the second semiconductor layer; and
forming a third insulation layer on a sidewall of the isolation region.

14. A method of manufacture of a semiconductor structure, comprising:
depositing a first layer of a thermally-conductive crystalline material on a semiconductor wafer or substrate;
depositing a layer of a semiconductor material on the first layer of the thermally-conductive crystalline material;
depositing a layer of a mask material on the layer of the semiconductor material;
forming a pattern on the layer of the mask material;
etching the pattern on the layer of the mask material;
etching the layer of the semiconductor material in accordance with the pattern and thereby forming an isolation region; and
depositing a second layer of the thermally-conductive crystalline material in the isolation region.

15. The method of claim 14, wherein the depositing a first layer of a thermally-conductive material comprises depositing a layer of a diamond material.

16. The method of claim 14, wherein the depositing a layer of a mask material comprises forming a layer of an oxide material.

17. The method of claim 14, wherein the depositing a layer of a mask material comprises forming a hard mask.

18. The method of claim 14, wherein the forming an isolation region comprises etching a trench.

19. The method of claim 14, wherein the depositing a second layer of the thermally-conductive crystalline material comprises depositing a second layer of a diamond material.

20. A method of manufacture of a semiconductor structure, comprising:
depositing an oxide layer;
forming a pattern on the oxide layer;
etching the pattern on the oxide layer and thereby forming an isolation region;
applying a crystal seed coating to a surface of the oxide layer and a surface of the isolation region;
cleaning the surface of the oxide layer; and
growing a thermally-conductive polycrystalline film from the crystal seed coating on the surface of the isolation region.

21. The method of claim 20, wherein the depositing the oxide layer comprises depositing a layer of a silicon oxide material on a silicon substrate.

22. The method of claim 20, wherein the applying comprises forming a plurality of diamond crystal nucleation sites on at least a bottom surface of a trench.

23. The method of claim 20, wherein the growing comprises forming at least one of a diamond film and a diamond damascene.

24. The method of claim 20, wherein the semiconductor structure comprises a semiconductor device.

25. The method of claim 20, further comprising:
forming a first spacer layer on a sidewall surface of the isolation region; and
forming a second spacer layer on the thermally-conductive polycrystalline film.

26. A semiconductor structure, comprising:
a semiconductor layer over a first thermal conduction layer;
an isolation region over the first thermal conduction layer; and
a second thermal conduction layer in the isolation region, wherein the second thermal conduction layer is thermally coupled to at least one of the first thermal conduction layer and the semiconductor layer.

27. The semiconductor structure of claim 26, wherein the semiconductor layer comprises a layer of a silicon material.

28. The semiconductor structure of claim 26, wherein each one of the first thermal conduction layer and the second thermal conduction layer comprises a layer of a thermally-conductive semiconductor crystalline material.

29. The semiconductor structure of claim 26, wherein each one of the first thermal conduction layer and the second thermal conduction layer comprises a layer of a diamond material.

30. The semiconductor structure of claim 26, wherein the second thermal conduction layer in the isolation region comprises a thermal conduction region.

31. The semiconductor structure of claim 26, wherein the isolation region further comprises a first spacer layer on a sidewall surface of the isolation region.

32. The semiconductor structure of claim 26, wherein the isolation region further comprises a first spacer layer on a sidewall surface of the isolation region, and a second spacer layer on the first spacer layer.

33. The semiconductor structure of claim 26, further comprising an isolation layer on the second thermal conduction layer.

34. An electronic system, comprising:
a power source unit;
a processor unit; and
a memory unit, wherein at least one of the power source unit, the processor unit, the memory unit, and a unit of other semiconductor devices includes at least one semiconductor structure comprising:
a semiconductor layer over a first thermal conduction layer;
an isolation region over the first thermal conduction layer; and
a second thermal conduction layer in the isolation region.

35. The electronic system of claim 34, wherein the semiconductor structure comprises a semiconductor device in at least one of an integrated circuit, a multi-chip module (MCM), and a stacked wafer package.

36. The electronic system of claim 34, wherein the semiconductor structure comprises at least one of a transistor, a capacitor, and a resistor.

37. The electronic system of claim 34, wherein the semiconductor layer comprises a layer of a silicon material, and the first thermal conduction layer and the second thermal conduction layer comprise a layer of a thermally-conductive polycrystalline semiconductor material.
